# EUROPEAN PATENT APPLICATION

(11) **EP 3 644 357 A1**
(43) Date of publication of application: **29.04.2020**
(21) Application number: 17906992.7
(22) Date of filing: 27.12.2017
(51) Int. Cl.: H01L 23/49

(54) **SURFACE-MOUNTED ELEMENT**

(30) Priority: 29.04.2017 CN 201710297717
(71) Applicant: Shenzhen Jinyang Electric Co., Ltd., Shenzhen, Guangdong 518000 (CN)
(72) Inventor: SHEN, Chaoyang, Shenzhen Guangdong 518000 (CN)
(74) Representative: Sun, Yiming
(86) International application number: PCT/CN2017/118998
(87) International publication number: WO 2018/196425

(57) **Abstract**

The disclosure provides a chip component including a body and a bracket; the bracket includes a first welding part, a second welding part, and a connection part connecting to the first welding part and the second welding part; the first welding part is configured to be welded to a printed circuit board (PCB); the body includes a first electrode and a second electrode; the first electrode is welded to the second welding part, and the second electrode is configured to weld to the PCB. One of the purposes of the disclosure is to provide a chip component that can meet the needs of automatic production, so as to improve the production efficiency and reduce the cost.

## Description

### TECHNICAL FIELD

The disclosure relates to the field of surface package, and more particularly to a chip component.

### BACKGROUND

In general, a surface package component comprises a power chip component and a leaded component. An existing chip component has a standard dimension, and it is easy to produce the chip component. However, for some power chip components, the price has been high for various reasons. On the other hand, conventional leaded components with the same performance are inexpensive, and in certain situations, the user has to spend a lot of time in manual soldering, thus affecting the efficiency, aesthetics, and consistency. Therefore, how to develop a chip component that meets the needs of automated production by using conventional piece-shaped components has become one of the technical problems to be solved by those skilled in the art.

### SUMMARY

To overcome the shortcomings of the art before the effective filling date of the disclosure, one of the purposes of the disclosure is to provide a chip component that can meet the needs of automatic production, so as to improve the production efficiency and reduce the cost.

The purpose of the disclosure is achieved by using the following technical solutions.

The disclosure provides a chip component comprising a body and a bracket; the bracket comprises a first welding part, a second welding part, and a connection part connecting to the first welding part and the second welding part; the first welding part is configured to weld to a printed circuit board (PCB); the body comprises a first electrode and a second electrode; the first electrode is welded to the second welding part, and the second electrode is configured to be welded to the PCB.

As an improvement, the first welding part and the second welding part are disposed at two sides of the connection part, respectively; the first welding part comprises a welding surface facing the PCB; the second electrode comprises a welding surface facing the facing the PCB; and the welding surfaces of the first welding part and the second electrode are the same.

As an improvement, the connection part comprises a first connection plate and a second connection plate connected to the first connection plate; the first connection plate is connected to the first welding part, and the second connection plate is connected to the second welding part.

As an improvement, an angle between the first connection plate and the first welding part is in a range of 90°-135°.

As an improvement, the angle between the first connection plate and the first welding part is 90°.

As an improvement, an angle between the second connection plate and the second welding part is in a range of 90°-135°.

As an improvement, the connection part further comprises a third connection plate; the first connection plate is connected to the second connection plate via the third connection plate.

As an improvement, the third connection plate and the first welding part are disposed at two sides of the first connection plate, respectively.

As an improvement, an angle between the third connection plate and the first connection plate is 90°.

As an improvement, a distance between the third connection plate and the first welding part is larger than a distance between the second welding part and the first welding part.

As an improvement, the bracket is piece-shaped.

As an improvement, the first welding part defines a slit.

As an improvement, the first electrode and the second electrode are disposed on surfaces of the body of the chip component.

As an improvement, the body of the chip component comprises a first surface and a second surface opposite to the first surface; the first electrode is disposed on the first surface and the second electrode is disposed on the second surface; and each edge of the first surface and the second surface is provided with a coating layer.

As an improvement, the coating layer is annular.

Compared with the art before the effective filling date of the disclosure , the chip component of the disclosure has the following advantages: the first electrode of the body of the chip component is welded to the second welding part of the bracket; when the body is welded to the PCB, the first welding part of the bracket and the second electrode of the body are welded to the PCB, thus the chip component formed by welding the body and the bracket can be welded by using a conventional welding device or method of the chip components. In addition, compared with conventional chip components , the chip component can be suitable for automated production and has a relatively low production cost which is beneficial to improving the market competitiveness, due to low raw material costs of the body and the bracket of the chip component,.

### BRIEF DESCRIPTION OF THE DRAWINGS

FIG. 1 is a schematic diagram of a chip component of a first embodiment;
FIG. 2 is a first schematic diagram of a bracket of the chip component in FIG. 1;
FIG. 3 is a second schematic diagram of the bracket of the chip component in FIG. 1;
FIG. 4 is a schematic diagram of a chip component of a second embodiment; and
FIG. 5 is a top view of a body of the chip component in FIG. 1.

Legends: 1. Body; 11. First electrode; 12. Second electrode; 2 Bracket; 21. First welding part; 22. Second welding part; 23. Connection part; 231. First connection plate; 232. Second connection plate; 233. Third connection plate; 3. Printed circuit board.

### DETAILED DESCRIPTION

Below, the disclosure is further described with reference to the drawings and the embodiments. It should be noted that, under the premise of no conflict, the embodiments described below or technical features can be arbitrarily combined to form a new embodiment.

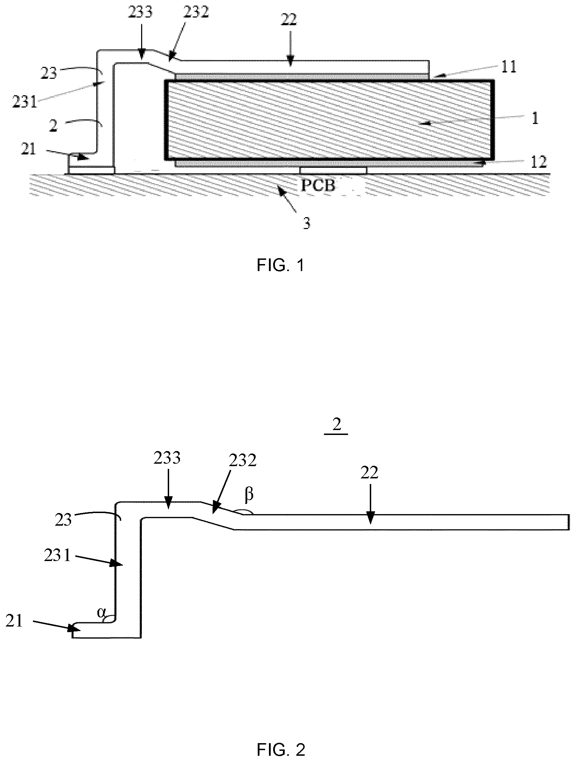

As shown in FIGS. 1 and 2, the disclosure provides a chip component comprising a body 1 and a bracket 2. The bracket 2 comprises a first welding part 21, a second welding part 22, and a connection part 23 connecting to the first welding part 21 and the second welding part 22. The first welding part 21 is configured to be welded to a printed circuit board (PCB) 3. The body 1 comprises a first electrode 11 and a second electrode 12 which are respectively disposed on two opposite sides (for example, in FIG. 1, the upper side and the lower side). The first electrode 11 is welded to the second welding part 22, and the second electrode 12 is configured to be welded to the PCB 3.

In the chip component, because the first electrode 11 of the body 1 is welded to the second welding part 22 of the bracket 2, when the body 1 is welded to the PCB 3, the first welding part 21 of the bracket 2 and the second electrode 12 of the body 1 are welded to the PCB 3, so that the chip component formed by welding the body 1 and the bracket 2 can be welded by using a conventional welding device or method of the chip components. In addition, the body 1 adopts an element commonly used in the market, and the bracket 2 can be a tinned steel strip. Thus, compared with conventional chip components, the chip component provided by the disclosure can be suitable for automated production, and has a relatively low production cost, which is beneficial to improving the market competitiveness.

As an improvement, the first welding part 21 and the second welding part 22 are disposed at two sides of the connection part 23, respectively. The distance between the first welding part 21 and the second welding part 22 is corresponding to the distance between the first electrode 11 and the second electrode 12. The structure is simple and reasonable, and can ensure that when the chip component is welded to the PCB 3, the welding surface of the first welding part 21 facing the PCB is in the same horizontal plane as the welding surface of the second electrode 12 facing the PCB, so that the chip component can be welded by using a conventional welding device or method, thus meeting the demand of automation production.

As an improvement, the connection part 23 comprises a first connection plate 231 and a second connection plate 232 connected to the first connection plate 231. The first connection plate 231 is connected to the first welding part 21, and the second connection plate 232 is connected to the second welding part 22.

An angle between the first connection plate 231 and the first welding part 21 is α, which is in a range of 90°-135°. In this example, preferably, the angle between the first connection plate and the first welding part is 90°. The design is beautiful, can prevent the damage of the bracket in a forming process, save the raw materials and reduce the cost of the chip component.

An angle between the second connection plate 232 and the second welding part 22 is β, which is in the range of 90°-135°. The design is beautiful, and can prevent the damage of the bracket in the forming process, save the raw materials and reduce the cost of the chip component.

The connection part 23 further comprises a third connection plate 233. The first connection plate 231 is connected to the second connection plate 232 via the third connection plate 233. In addition, the third connection plate 233 and the first welding part 21 are disposed at two sides of the first connection plate 231, respectively.

An angle between the third connection plate 233 and the first connection plate 231 is 90°. The design can save the raw materials and reduce the cost of the chip component. It is understandable that the angle between the third connection plate 233 and the second connection plate 232 is in the range of 90°-135°.

The distance between the third connection plate 233 and the first welding part 21 is larger than the distance between the second welding part 22 and the first welding part 21, so as to adjust the position of the first welding part 21 in the welding process, and ensure the welding surface of the first welding part 21 facing the PCB is in the same horizontal plane as the welding surface of the second electrode 12 facing the PCB, which is beneficial to welding.

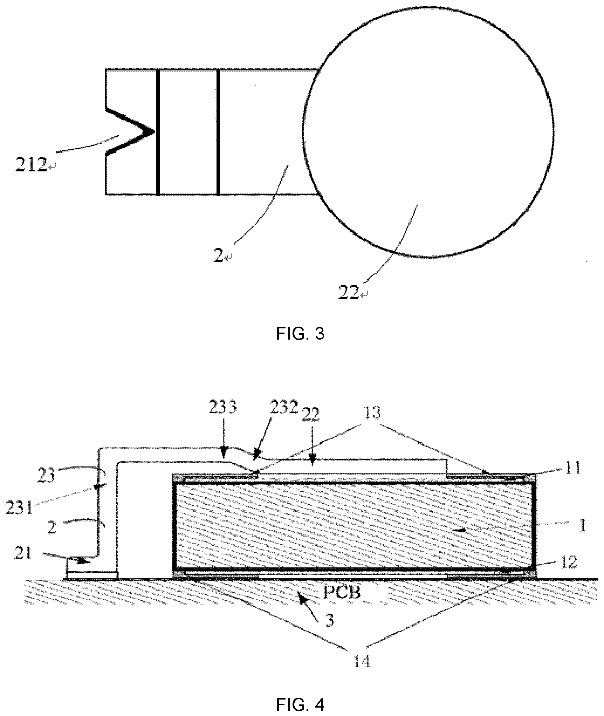

As shown in FIG. 3, preferably, the bracket is piece-shaped or plate-shaped. The first welding part 21 is piece-shaped. Preferably, the first welding part 21 defines a slit 212 for welding.

FIG. 4 is a schematic diagram of the chip component of a second embodiment.

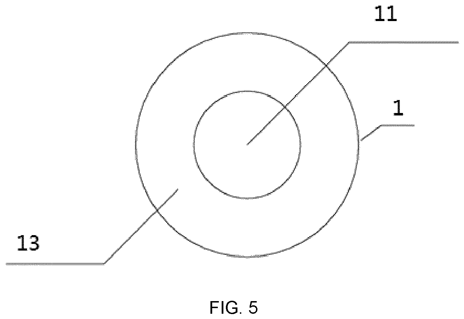

FIG. 5 is a top view of the body of the chip component in FIG. 4.

FIGS. 4 and 5 illustrate that the body of the chip component comprises a first surface and a second surface opposite to the first surface. The first electrode 11 and the second electrode 12 are disposed on the first surface and the second surface, respectively. Preferably, the first electrode 11 and the second electrode 12 are disposed on the centers of the first surface and the second surface, respectively. In this example, the areas of the first electrode 11 and the second electrode 12 are less than the areas of the first surface and the second surface. Chromatic circles 13, 14 are coated on the edges of the first surface and the second surface of the body 1, respectively, that is, outside the first electrode 11 and the second electrode 12. Preferably, the chromatic circles 13, 14 are evenly distributed on the edges of the two surfaces of the body 1. The chromatic circles 13, 14 can cover the edges of the first electrode 11 and the second electrode 12, and the centers of the first electrode 11 and the second electrode 12 are naked and exhibit the primary color of the electrode surfaces. The primary color of the electrode surfaces is used for electrical connection of components.

The chromatic circles 13, 14 can be used to distinguish electrical performance parameters of different specifications, such as blue indicating 270 VDC ± 10% and indicating 271, white indicating 470 VDC ± 10% and indicating 471; yellow indicating 510 VDC ± 10% and indicating 511, and so on. Preferably, the chromatic circles 13, 14 are symmetrically distributed on the first and second surfaces of the body 1 of the chip component. It can be understood that the chromatic circles 13, 14 may also not cover the edges of the electrodes 11, 12.

In conclusion, because the first electrode 11 of the body 1 of the chip component is welded to the second welding part 22 of the bracket 2, when the body 1 is welded to the PCB 3, the first welding part 21 of the bracket 2 and the second electrode 12 of the body 1 are welded to the PCB 3, so that the chip component formed by welding the body 1 and the bracket 2 can be welded by using a conventional welding device or method of the chip components. In addition, the body 1 and the bracket 2 of the chip component have low raw material costs, compared with conventional chip components, the chip component provided by the disclosure can be suitable for automated production, and has a relatively low production cost, which is beneficial to improving the market competitiveness.

The above embodiments are only preferred embodiments of the disclosure, and the scope of protection of the disclosure cannot be limited by the above embodiments. Any insubstantial changes and substitutions made by those skilled in the art based on the disclosure fall within the true spirit and scope of the disclosure.

## Claims

1. A chip component, comprising:
a body comprising:
a first electrode; and
a second electrode; and
a bracket comprising:
a first welding part configured to weld to a printed circuit board (PCB);
a second welding part; and
a connection part connecting to the first welding part and the second welding part;
wherein the first electrode is welded to the second welding part, and the second electrode is configured to be welded to the PCB.

2. The chip component of claim **1,** wherein the first welding part and the second welding part are disposed at two sides of the connection part, respectively; the first welding part comprises a welding surface facing the PCB; the second electrode comprises a welding surface facing the PCB; and the welding surfaces of the first welding part and the second electrode are the same.

3. The chip component of claim **1,** wherein the connection part comprises a first connection plate and a second connection plate connected to the first connection plate; the first connection plate is connected to the first welding part, and the second connection plate is connected to the second welding part.

4. The chip component of claim **3,** wherein an angle between the first connection plate and the first welding part is in a range of 90°-135°.

5. The chip component of claim **4,** wherein the angle between the first connection plate and the first welding part is 90°.

6. The chip component of claim **3,** wherein an angle between the second connection plate and the second welding part is in a range of 90°-135°.

7. The chip component of claim **3,** wherein the connection part further comprises a third connection plate; the first connection plate is connected to the second connection plate via the third connection plate.

8. The chip component of claim **7,** wherein the third connection plate and the first welding part are disposed at two sides of the first connection plate, respectively.

9. The chip component of claim **7,** wherein an angle between the third connection plate and the first connection plate is 90°.

10. The chip component of claim **7,** wherein a distance between the third connection plate and the first welding part is larger than a distance between the second welding part and the first welding part.

11. The chip component of claim **1,** wherein the bracket is piece-shaped.

12. The chip component of claim **1,** wherein the first welding part defines a slit.

13. The chip component of claim **1,** wherein the first electrode and the second electrode are disposed on surfaces of the body of the chip component.

14. The chip component of any of claims **1-13,** wherein the body of the chip component comprises a first surface and a second surface opposite to the first surface; the first electrode is disposed on the first surface and the second electrode is disposed on the second surface; and each edge of the first surface and the second surface is provided with a coating layer.

15. The chip component of claim **14,** wherein the coating layer is annular.
